(19) Europäisches Patentamt
European Patent Office
Office européen des brevets

(11) EP 1 582 967 B1

(12) EUROPÄISCHE PATENTSCHRIFT

(45) Veröffentlichungstag und Bekanntmachung des Hinweises auf die Patenterteilung:
**25.05.2011 Patentblatt 2011/21**

(51) Int Cl.:
***G06F 3/033*** *(2006.01)* ***C08J 7/04*** *(2006.01)*

(21) Anmeldenummer: **05005551.6**

(22) Anmeldetag: **15.03.2005**

(54) **Transparente, elektrisch leitfähige, beschichtete Polyesterfolie, Verfahren zu ihrer Herstellung sowie ihre Verwendung**

Transparent, electrically conductive, coated polyester film, process for its preparation and its use

Feuille de polyester revêtue, transparente et électroconductrice, procédé pour sa préparation et son utilisation

(84) Benannte Vertragsstaaten:
**DE FR GB IT LU**

(30) Priorität: **25.03.2004 DE 102004014645**

(43) Veröffentlichungstag der Anmeldung:
**05.10.2005 Patentblatt 2005/40**

(73) Patentinhaber: **Mitsubishi Polyester Film GmbH**
**65203 Wiesbaden (DE)**

(72) Erfinder:
- **Klein, Dagmar Dr.**
  **55126 Mainz (DE)**
- **Kliesch, Holger Dr.**
  **55252 Mainz (DE)**
- **Kiehne, Thorsten Dr.**
  **Nagahama**
  **Shiga, 526-0031 (JP)**
- **Kuhmann, Bodo**
  **65594 Runkel (DE)**
- **Hora, Franz**
  **65830 Kriftel (DE)**
- **Hilkert, Gottfried Dr.**
  **55291 Saulheim (DE)**
- **Wiederhold, Manfred**
  **65185 Wiesbaden (DE)**

(74) Vertreter: **Schweitzer, Klaus et al**
**Plate Schweitzer Zounek**
**Patentanwälte**
**Rheingaustrasse 196**
**65203 Wiesbaden (DE)**

(56) Entgegenhaltungen:
**EP-A- 0 962 486 EP-A- 1 471 415**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft eine transparente, elektrisch leitfähige, biaxial verstreckte, ein- oder mehrschichtige Polyesterfolie, die eine Beschichtung aus a) leitfähigen ITO (Indiumzinnoxyd)- oder ATO (Antimonzinnoxyd)-Partikeln oder eine Mischung davon enthält. Zusätzlich weist sie weitere leitfähige Komponenten b) auf. Diese befinden sich entweder in der ITO- und ATO-Partikel enthaltenden Schicht oder in einer damit in Kontakt stehenden Schicht. Unter einer leitfähigen Komponente b) ist auch eine Metallschicht zu verstehen, die die ITO-/ATO-Schicht kontaktiert. Die Folie wird nur vor dem Auftrag der ITO-/ATO-Beschichtung verstreckt oder relaxiert. Die Erfindung betrifft ferner ein Verfahren zur Herstellung der Folie sowie ihre Verwendung.

Transparent leitfähige Systeme (leitfähige Träger) sind z. B. für die Herstellung moderner Displays oder Solarzellen notwendig. Weitere Anwendungen sind Abschirmung gegen elektromagnetische Strahlung sowie allgemein Verwendung als Elektrodenmaterial.

Häufig verwendete Träger sind Glas und ähnliche Materialien. Für viele Anwendungen sind jedoch flexible Träger, wie beispielsweise Polyesterfolie, wünschenswert.

In der industriellen Praxis sind leitfähig beschichtete Folien in der Regel metallisiert. Solche Folien weisen in der Regel eine geringe Transparenz (< 30 %) für sichtbares Licht auf und müssen in einem Vakuumprozess metallisiert werden. Transparent leitfähige Folien weisen häufig eine durch Besputtern aufgebrachte Beschichtung mit ITO (Indiumzinnoxyd) oder ATO (Antimonzinnoxyd) auf (s. WO 2003/12799 von Toyo Boseki). Der Besputterungsprozess limitiert jedoch die Produktionsgeschwindigkeit und die Dimension des zu beschichtenden Artikels und ist somit unwirtschaftlich. Wünschenswert ist daher, die Folie mit einer Beschichtungsmethode beschichten zu können, die höhere Produktionsgeschwindigkeiten erlaubt. Eine solche Methode ist z. B. das Beschichten aus Lösung oder Dispersion, u. a. mittels Antragswalzen. Dafür ist es notwendig, die leitfähigen Bestandteile in eine Beschichtungslösung einzubringen. Leitfähige Beschichtungen können z. B. leitfähige, organische Polymere enthalten.

In JP-A-2000-188432 (TDK Corp., JP) und JP-A-2001-099924 (Sekisui Chem. Corp., JP) sind elektrisch leitfähige Beschichtungen auf Basis von nanoskaligem ITO bzw. ATO beschrieben. Die dort beschriebenen leitfähigen Beschichtungen haben jedoch den Nachteil, dass sie selbst eine geringe Flexibilität aufgrund der Sprödigkeit der ITO-Beschichtung aufweisen und deshalb ihre Leitfähigkeit bei mechanischer Beanspruchung wie Biegen verlieren.

Beschichtungen mit geringer Leitfähigkeit auf Basis organisch leitfähiger Komponenten im Bereich von $10^7$ bis $10^9$ Ohm/cm$^2$ sind in JP-C-2003-154594 und EP-B-1 020 762 beschrieben. Nachteile hier sind unter anderem die beschriebenen, geringen Leitfähigkeiten sowie die geringe Stabilität der verwendeten leitfähigen Materialien gegen oxydativen Abbau und UV-Licht (kleiner 380 nm).

Beschichtungen mit geringer Leitfähigkeit auf Basis organisch leitfähiger Komponenten im Bereich von $10^8$ bis $10^{10}$ Ohm/cm$^2$ sind in EP-B-0 962 486 beschrieben. Hier werden leitfähige anorganische Metalloxide mit leitfähigen organischen Polymeren gemischt und auf Polyesterfolie beschichtet. Nachteile hier sind unter anderem die beschriebenen geringen Leitfähigkeiten, und es fehlen Hinweise zur Transparenz der Folien. Ursachen für die geringe Performance der beschriebenen Folien dürften in der Beschichtungsmethode liegen, die auf eine noch nicht fertig kristallisierte Polyesterfolie erfolgt und sogar noch verstreckt wird und somit einem hohen mechanischen Stress unterliegt, der insbesondere bei Verwendung anorganischer Leiter zu einer Versprödung der Schicht mit Verlust eines Großteils der Leitfähigkeit und der Transparenz verbunden ist.

Gemeinsamer Nachteil aller zitierten Anwendungen ist, dass in der Regel keine Flächenwiderstände kleiner $10^7$ Ohm/cm$^2$ und erst recht keine kleiner $10^3$ Ohm/cm$^2$ erreicht werden können. Niedrigere Widerstände sind allerdings für viele Anwendungen notwendig.

Aufgabe der vorliegenden Erfindung ist es, eine Folie bereitzustellen, welche die genannten Nachteile nicht aufweist.

Gegenstand der Erfindung ist eine transparente, elektrisch leitfähige, biaxial verstreckte, ein- oder mehrschichtige Polyesterfolie, die dadurch gekennzeichnet ist, dass sie eine Beschichtung aufweist, die a) leitfähige ITO (Indiumzinnoxyd)- oder ATO (Antimonzinnoxyd)-Partikel oder eine Mischung davon und zusätzlich weitere leitfähige Komponenten b) enthält, wobei sich diese leitfähigen Komponenten b) entweder in der ITO- und ATO-Partikel enthaltenden Schicht oder in einer damit in Kontakt stehenden Schicht befinden.

Unter einer leitfähigen Komponente b) ist auch eine Metallschicht zu verstehen, die die ITO-/ATO-Schicht kontaktiert.

Ferner ist es möglich, dass die Folie mit einer weiteren leitfähigen Schicht ausgerüstet wird.

Die erfindungsgemäße Folie ist entweder ein- oder mehrschichtig.

Die leitfähige Beschichtung weist Flächenwiderstände von 10° bis $10^7$ Ohm/cm$^2$ auf.

Die Polyesterträgerfolie ist biaxial gestreckt und weist eine Dicke von 1 bis 500 μm, bevorzugt 8 bis 200 μm und besonders bevorzugt 12 bis 75 μm auf.

Die ITO- oder ATO-Partikel enthaltende Deckschicht weist eine Dicke von 0,05 bis 5 μm, bevorzugt 0,1 bis 3 μm und besonders bevorzugt 0,5 bis 1 μm auf.

Die Folie besitzt zur Verbesserung der Leitfähigkeit entweder

- zusätzlich zur ITO- oder ATO-Partikel enthaltenden Deckschicht mindestens eine weitere mit dieser Schicht in Kontakt stehende leitfähige Schicht, welche entweder eine Metallisierung oder eine Beschichtung mit einem leitfähigen Polymer ist,

oder/und

- zusätzlich zu den ITO- oder ATO-Partikeln mindestens ein leitfähiges Polymer in der Deckschicht.

In einer bevorzugten Ausführungsform weist die Folie gemäß der Erfindung in keiner Folienrichtung (weder in MD noch in TD) einen Schrumpf bei 200 °C von größer 25 % auf. Vorzugsweise beträgt der Schrumpf bei 200 °C ≤ 15 % und insbesondere ≤ 4 %.

In einer weiteren bevorzugten Ausführungsform weist die Folie in Querrichtung (TD) einen Schrumpf bei 200 °C ≤ 4 %, bevorzugt ≤ 2 % und besonders bevorzugt ≤ 1% auf.

Die Transparenz der Folie für Licht einer Wellenlänge im Bereich von 410 bis 750 nm liegt bei ≥ 25 %, bevorzugt ≥ 60 % und besonders bevorzugt ≥ 70 %.

Die erfindungsgemäßen ein- oder mehrschichtigen Folien weisen gute mechanische Eigenschaften auf. So beträgt der E-Modul in mindestens einer Folienrichtung (Längsrichtung (MD) und/oder Querrichtung (TD)) mindestens 500 N/mm$^2$, bevorzugt mindestens 2000 N/mm$^2$ und besonders bevorzugt mindestens 4000 N/mm$^2$. Die Reißfestigkeitswerte in mindestens einer Folienrichtung (Längsrichtung (MD) und/oder -Querrichtung (TD))sind ≥ 50 N/mm$^2$ bevorzugt ≥ 100N/mm$^2$ und besonders bevorzugt ≥ 150 N/mm$^2$. Die Reißdehnungswerte in mindestens einer Folienrichtung (Längsrichtung-(MD) und/oder-Querriehtung (TD)) betragen ≥ 10%, bevorzugt ≥ 40 % und besonders bevorzugt ≥ 80 %.

Die erfindungsgemäße ein- oder mehrschichtige Folie basiert auf Polyestern. Insbesondere die Basisschicht, aber auch die Deck- und/oder Zwischenschichten enthalten als Hauptpolymerbestandteil (d. h. zu 55 bis 100 Gew.-%, bevorzugt 70 bis 100 Gew.-% und besonders bevorzugt 90 bis 100 Gew.-%, bezogen auf die Masse der jeweiligen Schicht) einen Polyester.

Erfindungsgemäß versteht man unter einem Polyester

- Homopolyester,
- Copolyester,
- Blends verschiedener Polyester,

wobei diese sowohl als reine Rohstoffe, als auch als Rezyklat enthaltende Polyesterrohstoffe eingesetzt werden können.

Polyester enthalten Wiederholungseinheiten, die sich von Dicarbonsäuren (100 Mol-%) und Diolen (ebenfalls 100 Mol-%) ableiten. Die erfindungsgemäßen Polyester basieren bevorzugt auf Terephthalsäure oder 2,6-Naphthalindicarbonsäure als Dicarbonsäure und auf Ethylenglykol oder 1,4-Butandiol als Diol (PET, PBT oder PEN) oder Mischungen davon.

Insbesondere enthalten die erfindungsgemäßen Polyester 10 bis 100 Mol-% Terephthalat oder 10 bis 100 Mol-% 2,6-Naphthalat als Dicarbonsäurekomponenten, wobei die Gesamtmenge an Dicarbonsäurekomponenten 100 Mol-% ausmacht. Als weitere Dicarbonsäurekomponenten kann der erfindungsgemäße Polyester 0 bis 50 Mol-% 2,6-Naphthalat (wenn als Hauptkomponente Terephthalat eingesetzt wurde), 0 bis 50 Mol-% Terephthalat (wenn als Hauptkomponente Naphthalat verwendet wurde), 0 bis 20 Mol-% Isophthalat, bevorzugt 0,5 bis-1-0 Mol-% und besonders bevorzugt 2 bis 6 Mol-%, sowie 10 bis 60 Mol-% 4,4'-Diphenyldicarboxylat enthalten. Andere Dicarbonsäurekomponenten wie 1; 5-Naphthalindicarboxylat sollen gegebenenfalls einen Anteil von 30 Mol-%, bevorzugt 10 Mol-%, besonders bevorzugt 2 Mol-%, nicht überschreiten.

Als Diolkomponente enthält der erfindungsgemäße Polyester im allgemeinen 10 bis 100 Mol-% Ethylenglykol (EG), wobei die Gesamtmenge an Diolkomponenten 100 Mol-% ausmacht. Werden Mischungen verschiedener Diole eingesetzt, ist es vorteilhaft, den Anteil an Diethylenglykol mit 10 Mol-% nicht zu überschreiten und vorzugsweise 0,5 bis 5 Mol-% einzusetzen. Andere Diolkomponenten wie Cyclohexandimethanol, 1,3-Propandiol, 1,4-Butandiol sollen zweckmäßigerweise einen Anteil von 50 Mol-% nicht überschreiten und liegen bevorzugt bei einem Anteil von ≤ 30 Mol-%, besonders bevorzugt bei ≤ 10 Mol-%.

Es können auch Mischungen der Polyester eingesetzt werden.

Die Polyesterzusammensetzung funktioneller Deckschichten kann von dem oben beschriebenen abweichen und ist beispielsweise im nachfolgenden Text, betreffend siegelfähige Deckschichten, beschrieben.

Neben den genannten Hauptpolymerbestandteilen können die Schichten der Folie in weiteren Ausführungsformen bis zu 45 Gew.-%, bevorzugt bis zu 30 Gew.-%, besonders bevorzugt bis zu 20 Gew.-%, bezogen auf die Masse der jeweiligen Folienschicht, andere Polymere wie Polyetherimide (z. B. Ultem® 1000 der Fa. GE Plastics Europe, NL),

Polycarbonat (z. B. Makrolon® der Fa. Bayer, DE), Polyolefine wie COCs (z. B. Topas® der Fa. Ticona, DE), Polyamide (z. B. Ultramid® der Fa. BASF, DE) u. a. enthalten.

Allgemein werden die Polyester nach literaturbekannten Verfahren aus den genannten Diolen und Dicarbonsäure oder Dicarbonsäureester hergestellt. Die Herstellung der Polyester kann sowohl nach dem Umesterungsverfahren mit den üblichen Katalysatoren wie z. B. Zn-, Ca-, Li- und Mn Salzen oder nach dem Direktveresterungsverfahren erfolgen.

Die mehrschichtigen Folien bestehen mindestens aus einer Basisschicht B, mindestens einer Deckschicht A oder C und gegebenenfalls weiteren Zwischenschichten, wobei insbesondere ein dreischichtiger A-B-A- oder A-B-C-Aufbau bevorzugt ist. Für diese Ausführungsform ist es vorteilhaft, wenn das Polymer der Basisschicht B eine ähnliche Schmelzeviskosität besitzt wie jene(s) der Deckschicht(en), die an die Basisschicht angrenzt (angrenzen).

In einer bevorzugten Ausführungsform ist die funktionelle Schicht C siegelfähig. Diese durch Coextrusion auf die Basisschicht B aufgebrachte siegelfähige Deckschicht ist auf Basis von Polyestercopolymeren aufgebaut. Bevorzugt im Sinne der Erfindung sind dabei zwei Varianten:

A: Copolyester aus Terephthalsäure und Isophthalsäure
B: Copolyester aus Terephthalsäure und Naphthalindicarbonsäure

Variante A

Das Polymer der siegelfähigen Deckschicht besteht aus Copolyestern, die überwiegend, d. h. zu mindestens 70 bis 95 Mol-% aus Isophthalsäure- und Terephthalsäure-Komponenten auf der Dicarbonsäureseite und 70 bis 95 Mol-% aus Ethylenglykolkomponenten auf der Diolseite zusammengesetzt sind. Die restlichen Monomereinheiten stammen aus anderen aliphatischen, cycloaliphatischen oder aromatischen Diolen bzw. Dicarbonsäuren, wie sie auch in der Basisschicht vorkommen können. Die bevorzugten Copolyester, die die gewünschten Siegeleigenschaften bereitstellen, sind solche, die aus Ethylenterephthalat- und Ethylenisophthalatkomponenten aufgebaut sind. Der Anteil an Ethylenterephthalat beträgt 40 bis 95 Mol-% und der entsprechende Anteil an Ethylenisophthalat 60 bis 5 Mol-%. Bevorzugt sind Copolyester, bei denen der Anteil an Ethylenterephthalat 50 bis 90 Mol-% und der entsprechende Anteil an Ethylenisophthalat 50 bis 10 Mol-% beträgt, und ganz bevorzugt sind Copolyester, bei denen der Anteil an Ethylenterephthalat 60 bis 85 Mol-% und der entsprechende Anteil an Ethylenisophthalat 40 bis 15 Mol-% beträgt.

Variante B

Das Polymer der siegelfähigen Deckschichtbesteht aus Copolyestern, die überwiegend, d. h. zu mindestens 70 bis 95 Mol-% aus Naphthalindicarbonsäure- und Terephthalsäurekomponenten auf der Dicarbonsäureseite und aus Ethylenglykolkomponenten auf der Diolseite zusammengesetzt sind. Die restlichen Monomereinheiten stammen aus anderen aliphatischen, cycloaliphatischen oder aromatischen Diolen bzw. Dicarbonsäuren, wie sie auch in der Basisschicht vorkommen können. Die bevorzugten Copolyester, die die gewünschten Siegeleigenschaften bereitstellen, sind solche, die aus Ethylenterephthalat- und Ethylennaphthalatkomponenten aufgebaut sind. Der Anteil an Ethylenterephthalat beträgt 30 bis 75 Mol-% und der entsprechende Anteil an Ethylennaphthalat 70 bis 25 Mol-%. Bevorzugt sind Copolyester, bei denen der Anteil an Ethylenterephthalat 40 bis 60 Mol% und der entsprechende Anteil an Ethylennaphthalat 60 bis 40 Mol-% beträgt. Sollte der Gehalt an Polyethylennaphthalat (PEN) in der Siegelschicht nicht ausreichen, um den erfindungsgemäßen Gesamtgehalt an PEN in der Folienschicht zu erreichen, so sollte zweckmäßigerweise der fehlende PEN-Anteil der Basisschicht hinzugefügt werden, und es sollte zweckmäßigerweise eine PEN-freie Deckschicht aufgebracht werden.

Die Varianten A und B können miteinander kombiniert werden. Die Mindestmengen an Isophthalsäure (IPA) bzw. PEN lassen sich dadurch verringern. Es hat sich bei PET/PEN/Polyethylenisophthalat-Siegelschichten (PET=Polyethylenterephthalat) jedoch als günstig erwiesen, wenn der PEN-Anteil der Siegelschicht bei mindestens 15 Gew.-% und der Polyethylenisophthalatanteil bei mindestens 5 Gew.-% liegt.

Die Dicke der Deckschicht/en wird unabhängig von den anderen Schichten gewählt und liegt im allgemeinen im Bereich von 0,1 bis 10 μm, bevorzugt 0,2 bis 5 μm und besonders bevorzugt 1 bis 3 μm, wobei beidseitig aufgebrachte Deckschichten bezüglich Dicke und Zusammensetzung gleich oderverschieden sein können. Die Dicke der Basisschicht ergibt sich entsprechend aus der Differenz von Gesamtdicke der Folie und der Dicke der aufgebrachten Deck- und Zwischenschicht/en und kann daher analog der Gesamtdicke innerhalb weiter Grenzen variieren

Die erfindungsgemäße Folie kann in einer oder mehreren Schichten weitere partikuläre Additive wie Füllstoffe und Antiblockmittel enthalten. Typische Füllstoffe und Antiblockmittel sind anorganische und/oder organische Partikel, beispielsweise Siliziumdioxid (natürlich, gefällt oder pyrogen), Calciumcarbonat, Magnesiumcarbonat, Bariumcarbonat, Calciumsulfat, Bariumsulfat, Lithiumphosphat, Calciumphosphat, Magnesiumphosphat, Titandioxid (Rutil oder Anatas), Kaolin (hydratisiert oder calciniert), Aluminiumoxid, Aluminiumsilikate, Lithiumfluorid, Calcium-, Barium-, Zink- oder Mangansalze der eingesetzten Dicarbonsäuren oder vernetzte Polymerpartikel, z. B. Polystyrol oder Polymethylmethacrylatpartikel.

Es können auch Mischungen von zwei oder mehreren der oben genannten Partikelsysteme oder Mischungen von Partikelsystemen mit gleicher chemischer Zusammensetzung, aber unterschiedlicher Partikelgröße gewählt werden. Die Partikel werden dem Polyester zweckmäßigerweise schon vor dem Aufschmelzen zugesetzt.

Sofern in einer Schicht der Folie weitere partikuläre Additive enthalten sind, beträgt die Gesamtkonzentration dieser Partikel im allgemeinen ≤ 10 Gew.-%, bezogen auf die Gesamtmasse der ausgerüsteten Schicht, bevorzugt ≤ 5 Gew.-% und besonders bevorzugt ≤ 1 Gew.-%. Die partikulären Additive haben eine mittlere Größe ($d_{50}$-Wert) von 0,01 bis 10 μm, bevorzugt 0,03 bis 5 μm und besonders bevorzugt 0,05 bis 1 μm. In einer bevorzugten Ausführungsform liegt der Anteil von Partikeln mit einem $d_{50} \geq 3$ μm bei ≤ 1000 ppm, bevorzugt bei ≤ 300 ppm und besonders bevorzugt bei ≤ 100 ppm.

In einer bevorzugten Ausführungsform enthält die Folie 0,1 bis 2 Gew.-%, bevorzugt 0,5 bis 1,5 Gew.-%, Siliziumdioxid-Partikel mit einem $d_{50} \leq 1$ μm und 0 bis 500 ppm Siliziumdioxidpartikel mit einem $d_{50}$ größer 1 μm und ≤ 3 μm.

Die erfindungsgemäße Folie kann weitere Additive wie UV-Stabilisatoren, Flammschutzmittel, Hydrolysestabilisatoren und Antioxidantien enthalten.

In einer bevorzugten Ausführungsform weist die Basisfolie vor der off-line-Beschichtung eine Trübung von ≤ 4 %, bevorzugt ≤ 3% und besonders bevorzugt von ≤ 2 %, auf. Zum Erreichen dieser bevorzugten Ausführungsform hat es sich als vorteilhaft erwiesen, wenn Titanverbindungen ≤ 50 ppm, bevorzugt ≤ 20 ppm als Polykondensationskatalysator zur Herstellung des Polyesters verwendet werden. Weiterhin ist es zweckmäßig, dass sonstige Katalysatorkomponenten wie Umesterungskatalysatoren (z. B. Mangansalze) und phosphorhaltige Stabilisatoren zusammen einen Gehalt von 150 ppm, bevorzugt 100 ppm und besonders bevorzugt 75 ppm, nicht überschreiten.

In einer weiteren Ausführungsform ist die erfindungsgemäße Folie in mindestens einer ihrer Schichten flammhemmend ausgerüstet. Flammhemmend bedeutet, dass die Folie in einer sogenannten Brandschutzprüfung gemäß UL94 VTM mindestens die Klasse VTM-2 erreicht. Die Folie enthält dann in einer oder mehreren Schichten ein Flammschutzmittel in einer Konzentration im Bereich von 0,2 bis 30 Gew.-%, bevorzugt 0,5 bis 25 Gew.-%, besonders bevorzugt von 1 bis 20 Gew.-%, bezogen auf die Masse der ausgerüsteten Schicht. Wesentlich ist, dass das Flammschutzmittel im Polyester löslich ist, da andernfalls die geforderten mechanischen Eigenschaften nicht erreicht werden. Geeignete Flammschutzmittel sind beispielsweise organische Brom-, Chlor- oder Stickstoffverbindungen oder Metallhydroxide oder -trihydrate. Die Halogenverbindungen haben allerdings den Nachteil, dass im Brandfall toxische und korrosiv wirkende Halogenwasserstoffe entstehen. Nachteilig ist auch die geringe Lichtbeständigkeit einer damit ausgerüsteten Folie. Weitere geeignete Flammschutzmittel sind beispielsweise organische Phosphorverbindungen wie Carboxyphosphinsäuren, deren Anhydride und Methanphosphonsäuredimethylester. Sehr geeignet sind hierbei Flammschutzmittel, bei denen die Phosphorverbindung chemisch an den Polyester gebunden ist. Ganz besonders bevorzugt ist [(6-oxido-6H-dibenz[c,e][1,2]oxaphosphorin-6-yl)methyl]butandicarbonsäure-bis-(2-hydroxy ethyl)ester mit der Formel

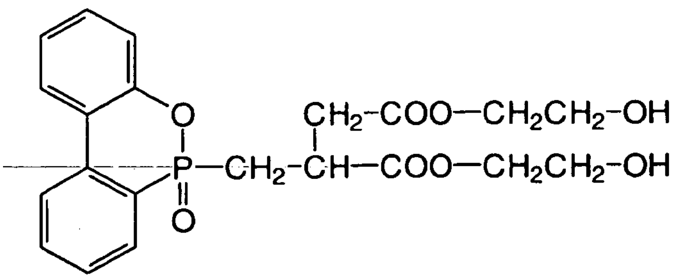

In dieser bevorzugten Ausführungsform enthält die erfindungsgemäße schwer entflammbare Folie neben dem Polyester, der Strahlung aktivierbaren Verbindung und gegebenenfalls partikulären Additiven 1 bis 20 Gew.-% einer im Polyester löslichen organischen Phosphorverbindung als Flammschutzmittel.

Da die Flammschutzmittel im allgemeinen eine gewisse Hydrolyseempfindlichkeit aufweisen, kann der zusätzliche Einsatz eines Hydrolysestabilisators sinnvoll sein. Geeignete Hydrolysestabilisatoren sind beispielsweise polymere Carbodiimide wie z. B. Stabaxol® P der Fa. Rheinchemie (DE). Diese werden bevorzugt in einer Menge von 0,1 bis 1 Gew.-%, bezogen auf die Masse der ausgerüsteten Schicht, eingesetzt.

Diese oben genannten Anteile an Flammschutzmittel und Hydrolysestabilisator haben sich auch dann als günstig erwiesen, wenn der Hauptbestandteil der Folie nicht Polyethylenterephthalat, sondern ein anderer Polyester ist.

In einer weiteren bevorzugten Ausführungsform enthält die transparente Folie mindestens einen UV-Stabilisator als Lichtschutzmittel, der zweckmäßigerweise über die so genannte Masterbatch-Technologie direkt bei der Folienherstellung zudosiert wird, wobei die Konzentration des UV-Stabilisators vorzugsweise zwischen 0,01 Gew.-% und 5 Gew.-

%, bezogen auf das Gewicht der Schicht des kristallisierbaren Thermoplasten, liegt. Dieses ist besonders vorteilhaft, da der ultraviolette Anteil des Lichts, d. h. der Wellenlängenbereich von 280 bis 400 nm, die in der bevorzugten Ausführungsform in der leitfähigen Schicht enthaltenen organisch leitfähigen Polymere schädigt.

Geeignete UV-Stabilisatoren als Lichtschutzmittel sind UV-Stabilisatoren, die mindestens 70 %, bevorzugt 80 % und besonders bevorzugt 90 %, des UV-Lichts im Wellenlängenbereich von 180 bis 380 nm, bevorzugt 280 bis 350 nm, absorbieren. Diese sind insbesondere geeignet, wenn sie im Temperaturbereich von 260 bis 300 °C thermisch stabil sind, d.h. sich nicht zersetzen und nicht zur Ausgasung führen. Geeignete UV-Stabilisatoren als Lichtschutzmittel sind beispielsweise 2-Hydroxybenzophenone, 2-Hydroxybenzotriazole, nickelorganische Verbindungen, Salicylsäureester, Zimtsäureester-Derivate, Resorcinmonobenzoate, Oxalsäureanilide, Hydroxybenzoesäureester, sterisch gehinderte Amine und Triazine, wobei die 2-Hydroxybenzotriazole und die Triazine bevorzugt sind.

In einer besonders bevorzugten Ausführungsform enthält die erfindungsgemäße transparente Folie 0,01 bis 5 Gew.-% 2-(4,6-Diphenyl-1,3,5-triazin-2-yl)-5-(hexyl)oxyphenol oder 0,01 bis 5 Gew.-% 2,2'-Methylen-bis(6-(2H-benzotriazol-2-yl)-4-(1,1,3,3-tetramethylbutyl)-phenol. In einer bevorzugten Ausführungsform können auch Mischungen dieser beiden UV-Stabilisatoren oder Mischungen von mindestens einem dieser beiden UV-Stabilisatoren mit anderen UV-Stabilisatoren eingesetzt werden, wobei die Gesamtkonzentration an Lichtschutzmittel vorzugsweise im Bereich von 0,01 bis 5 Gew.-%, bezogen auf das Gewicht an Polymer, liegt.

In einer weiteren bevorzugten Ausführungsform weist die erfindungsgemäße Folie eine erhöhte Sauerstoffbarriere auf, die z. B. durch Beschichtung und Additive, wie sie z. B. in den beiden unveröffentlichten deutschen Anmeldungen 103 02 035.7 und 103 02 036.5 beschrieben sind, erreicht werden kann.

Die verwendeten weiteren Additive wie Partikel, UV-Stabilisatoren, Flammschutzmittel, Hydrolysestabilisatoren und Antioxidantien können dem zur Herstellung der erfindungsgemäßen Folie verwendeten Polyester als glykolische Dispersion während der Polykondensation zugegeben werden. Bevorzugt ist jedoch die Zugabe der verwendeten weiteren Additive über Masterbatche zum Polyesterrohstoff während der Folienextrusion.

Ebenso kann die Folie zur Einstellung weiterer Eigenschaften beschichtet werden. Typische Beschichtungen sind insbesondere haftvermittelnd, schlupfverbessernd oder dehäsivwirkende Schichten. Es bietet sich an, diese zusätzlichen Schichten über in-line coating mittels wässriger Dispersionen nach der Längs- und vor der Querstreckung auf die Folie aufzubringen.

In einer besonderen Ausführungsform weist die Folie einseitig eine Silikonbeschichtung auf wie sie z. B. in US-A 5,728,339 beschrieben ist. Diese Ausführungsform hat den Vorteil, dass Verunreinigungen leichter von der leitfähig beschichteten Folie entfernt werden können, sofern diese gleichzeitig die Außenschicht eines Displays oder anderen elektronischen Bauteils darstellt.

Für bestimmte Anwendungen kann es zweckmäßig sein, die Oberfläche der Folie mit einer Säure chemisch vorzubehandeln. Für diese sogenannte Ätzhaftvermittlung eignen sich insbesondere Trichloressigsäure, Dichloressigsäure oder Flusssäure, die für eine kurze Zeit (zwischen 5 und 120 s) auf die Oberfläche einwirken und dann mittels Luftmesser wieder entfernt werden. Dadurch erhält die Folie eine sehr reaktive, amorphe Oberfläche.

In einer bevorzugten Ausführungsform wird mindestens eine Oberfläche der Folie mit einer wässrigen Lösung bzw. Dispersion einer hydrolysierten Aminosilanverbindung beschichtet. Die Beschichtung wird bevorzugt in-line aufgebracht, d. h. während des Folienherstellungsprozesses, zweckmäßigerweise vor der Querstreckung. Besonders bevorzugt ist die Aufbringung der Beschichtung mittels des "Reverse Gravure Roll Coating"-Verfahrens, bei dem sich die Beschichtung äußerst homogen auftragen lässt. Ebenfalls bevorzugt ist die Aufbringung der Beschichtung durch das "Meyer-Rod"-Verfahren, mit dem sich größere Beschichtungsstärken erzielen lassen. Die Beschichtung wird als verdünnte wässrige Lösung bzw. Dispersion auf die Folie gebracht und anschließend das Lösungsmittel bzw. Dispersionsmittel verflüchtigt. Wird die Beschichtung in-line vor der Querstreckung aufgebracht, reicht gewöhnlich die Temperaturbehandlung in der Querstreckung aus, um das Lösungsmittel bzw. Dispersionsmittel zu verflüchtigen und die Beschichtungzutrocknen

Geeignete Aminosilanverbindungen haben im unhydrolysierten Zustand die-allgemeine Formel

$$(R^1)_aSi(R^2)_b(R^3)_c$$

wobei $R^1$ eine funktionelle Gruppe mit mindestens einer primären Aminogruppe, bevorzugt mit der Formel $-X-Y-Z-NH_2$ mit $X=C_1-C_4$-Alkylen o. $C_6-C_{10}$-Arylen, Y= O, NH oder Bindung, $Z=C_1-C_4$-Alkylen o. $C_6-C_{10}$-Arylen, $R^2$ eine hydrolysierbare Gruppe, ausgewählt aus der Gruppe, bestehend aus einer Alkoxygruppe mit 1 bis 8 Kohlenstoffatomen, einer Acetoxygruppe und einem Halogenid, und $R^3$ eine unreaktive, nicht hydrolysierbare Gruppe, ausgewählt aus der Gruppe, bestehend aus einer Alkylgruppe mit 1 bis 8 Kohlenstoffatomen und einer Phenylgruppe, bedeutet. Der Koeffizient a ist $\geq 1$, der Koeffizient b ist ebenfalls $\geq 1$, der Koeffizient c ist $\geq 0$ und a+b+c = 4.

Als Aminosilanverbindung ist N-(2-Aminoethyl)-3-aminopropyltrimethoxysilan der Formel

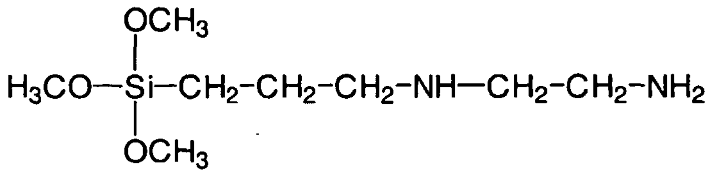

bevorzugt. Diese Verbindung wird unter der Bezeichnung Z-6020 kommerziell von der Fa. Dow Corning (DE) angeboten.

Die oben beschriebene erfindungsgemäße Beschichtung ist ausführlich in EP-B-0 359 017 beschrieben, auf die an dieser Stelle ausdrücklich Bezug genommen wird. Diese Druckschrift beschreibt auch weitere geeignete Aminosilanverbindungen, auf deren Wiedergabe hier verzichtet wird, die aber von der vorliegenden Erfindung ausdrücklich mit umfasst sind.

Die Beschichtung enthält neben Aminosilanverbindungen gleichzeitig die weiter unten beschriebenen organisch leitfähigen Komponenten in den unten angegebenen Mengen und stellt so eine haftvermittelnde leitfähige Beschichtung dar.

Völlig überraschend hat sich gezeigt, dass eine Folie, die mit dem getrockneten Rückstand einer hydrolysierten Aminosilanverbindung in einer Menge von 0,5 bis 100 mg/m$^2$, bevorzugt 2 bis 50 mg/m$^2$ und besonders bevorzugt 10 bis 25 mg/m$^2$, beschichtet ist, auf der beschichteten Seite eine deutlich verbesserte Haftung der ITO-Partikel enthaltenden Beschichtung auf der Folie zeigt.

Wenn die Aminosilanbeschichtung gleichzeitig organisch leitfähige Komponenten enthält, hat es sich als sinnvoll erwiesen, wenn der getrocknete Rückstand bezogen auf den reinen Aminosilananteil bei $\leq$ 10, bevorzugt $\leq$ 7,5 und besonders bevorzugt bei $\leq$ 5 mg/m$^2$, liegt.

In einer weiteren bevorzugten Ausführungsform wird mindestens eine Seite der Folie mit einer wässrigen Dispersion beschichtet, die die vorstehend genannten Eigenschaften verbessernden Verbindungen enthält. Die Beschichtung auf der fertigen Folie weist eine Dicke von 5 bis 1000 nm, bevorzugt 10 bis 500 nm, besonders bevorzugt 20 bis 200 nm, auf. Die Beschichtung wird bevorzugt in-line aufgebracht, d. h. während des Folienherstellprozesses, zweckmäßigerweise vor der Querstreckung. Besonders bevorzugt ist die Aufbringung der Beschichtung mittels des "Reverse gravure-roll coating"-Verfahrens, bei dem sich die Beschichtungen äußerst homogen in Schichtdicken bis 200 nm auftragen lassen. Ebenfalls bevorzugt ist die Aufbringung der Beschichtung durch das Meyer-Rod-Verfahren, mit dem sich größere Beschichtungsstärken erzielen lassen. Die Beschichtung wird bevorzugt als Lösung, Suspension oder Dispersion aufgetragen, besonders bevorzugt als wässrige Lösung, Suspension oder Dispersion. Die genannte Beschichtung verleiht der Folienoberfläche bzw. der Folie die gewünschten Funktionen (niedriger Reibkoeffizient, gute Verarbeitbarkeit, gute Rollenaufmachung, geringe statische Aufladung, bessere Bedruck- und Verklebbarkeit) und mögliche weitere Funktionen. Beispielsweise kann die Folie dadurch mit verbesserter Aromabarriere ausgerüstet sein oder die Haftung zu Materialien ermöglichen,die ansonsten nicht auf der Folienoberfläche haften würden, z. B. photographische Emulsionen.

Die genannten Stoffe/Zusammensetzungen werden als verdünnte Lösung, Emulsion oder Dispersion, vorzugsweise als wässrige Lösung, Emulsion oder Dispersion auf eine oder beide Folienoberflächen aufgebracht und anschließend das Lösungsmittel/das Dispersionsmittel verflüchtigt. Wird die Beschichtung in-line vor der Querstreckung aufgebracht, reicht gewöhnlich die Temperaturbehandlung in der Querstreckung und die anschließende Hitzefixierung aus, um das Lösungsmittel/das Dispersionsmittel zu verflüchtigen und die Beschichtung zu trocknen.

Als Feststoffbestandteil enthält die wässrige Dispersion Acrylcopolymere. Die bevorzugt verwendeten Copolymeren bestehen im Wesentlichen aus mindestens 50 Gew.-% eines oder mehrerer polymerisierter acrylischer und/oder methacrylischer Monomerer und 1 bis 15 Gew.-% eines copolymerisierbaren Comonomeren, das in copolymerisiertem Zustand unter Einwirkung erhöhter Temperatur, gegebenenfalls ohne Zusatz eines gesonderten harzförmigen Venetzungsmittels, zur Ausbildung von intermolekularen Vernetzungen befähigt ist.

Die acrylische Komponente der Copolymere ist vorzugsweise in einer Menge von 50 bis 99 Gew.-% anwesend und besteht bevorzugt aus einem Ester der Methacrylsäure, insbesondere einem Alkylester, dessen Alkylgruppe bis zu 10 C-Atome enthält wie z. B. die Methyl-, Ethyl-, n-Propyl-, Isopropyl-, n-Butyl-, Isobutyl-, tertiäre Butyl-, Hexyl-, 2-Ethylhexyl-, Heptyl- und n-Octylgruppe. Acrylcopolymere, die von einem niederen Alkylacrylat ($C_1$ bis $C_4$) abgeleitet sind, insbesondere Ethylacrylat, ergeben zusammen mit einem niederen Alkylmethacrylat eine besonders gute Haftung zwischen der Polyesterfolie und darauf aufgebrachten reprografischen Beschichtungen und Mattbeschichtungen. Ganz besonders bevorzugt werden Haftvermittlercopolymere aus einem Alkylacrylat, z. B. Ethylacrylat oder Butylacrylat, zusammen mit einem Alkylmethacrylat, z. B. Methylmethacrylat, insbesondere zu gleichen molaren Anteilen und in einer Gesamtmenge von 70 bis 95 Gew.-%, eingesetzt. Das Acrylatcomonomere solcher Acryl-/Methacrylkombinationen ist vorzugsweise in einem Anteil von 15 bis 65 Mol-% anwesend und das Methacrylatcomonomere vorzugsweise in einem Anteil, der im allgemeinen um 5 bis 20 Mol-% größer ist als der Anteil des Acrylatcomonomeren. Das Methacrylat ist

vorzugsweise in einem Anteil von 35 bis 85 Mol-% in der Kombination enthalten.

Zur Erhöhung der Lösungsmittelbeständigkeit können gegebenenfalls zur Ausbildung von Vernetzungen geeignete Comonomere eingesetzt werden wie N-Methylolacrylamid, N-Methylolmethacrylamid und die entsprechenden Ether; Epoxidmaterialien wie Glycidylacrylat, Glycidylmethacrylat und Allylglycidylether; Carboxylgruppen enthaltende Monomere wie Crotonsäure, Itaconsäure oder Acrylsäure; Anhydride wie Maleinsäureanhydrid oder Itaconsäureanhydrid; Hydroxylgruppen enthaltende Monomere wie Allylalkohol und Hydroxyethyl- oder Hydroxypropylacrylat oder -methacrylat; Amide wie Acrylamid, Methacrylamid oder Maleinsäureamid und Isocyanate wie Vinylisocyanat oder Allylisocyanat. Von den oben genannten vernetzenden Comonomeren werden N-Methylolacrylamid und N-Methylolmethacrylamid bevorzugt, und zwar in erster Linie deswegen, weil Copolymerketten, die eines dieser Monomere enthalten, unter der Einwirkung erhöhter Temperaturen zur Kondensation miteinander und somit zur Ausbildung der gewünschten intermolekularen Vernetzungen befähigt sind. Die gegebenenfalls gewünschte Lösungsmittelbeständigkeit der bevorzugten Acrylatbeschichtung kann aber auch durch die Anwesenheit eines fremden Vernetzungsmittels, z. B. eines Melamin- oder Harnstoff-Formaldehyd-Kondensationsproduktes, erzielt werden. Wird keine Lösungsmittelbeständigkeit benötigt, so kann auf Vernetzungsmittel verzichtet werden.

Die oben beschriebene erfindungsgemäße Beschichtung ist ausführlich in der EP-A-0 144 948 dargestellt, auf die an dieser Stelle ausdrücklich Bezug genommen wird. Diese Schrift gibt auch Auskunft über weitere spezifische Kombinationen solcher gemischten Acrylcopolymeren.

Die Additive, z-B.Partikel, UV-Stabilisatoren usw.-,können mittels eines handelsüblichen Zweischneckenextruders in das Polymer eingebracht werden. Dabei wird ein Polyestergranulat zusammen mit den Partikeln/Additiven in den Extruder eingebracht und extrudiert, anschließend in einem Wasserbad abgeschreckt und dann granuliert.

In einem bevorzugten Verfahren zur Herstellung der erfindungsgemäß eingesetzten Polyester werden die Additive aber direkt bei der Polyesterherstellung zugegeben. Üblicherweise werden die Additive im Falle des DMT-Verfahrens nach der Umesterung bzw. direkt vor der Polykondensation, z. B. über die Transportleitung zwischen Umesterungs- und Polykondensationskessel, als glykolische Dispersion zugegeben. Die Zugabe kann aber auch schon vor der Umesterung erfolgen. Im Falle des TPA-Verfahrens erfolgt die Zugabe bevorzugt zu Beginn der Polykondensation. Eine spätere Zugabe ist jedoch auch möglich. Es hat sich bei diesem Verfahren als günstig erwiesen, wenn die glykolischen Dispersionen vor der Zugabe über einen PROGAF PGF 57 (Hayward Ind., US) Filter filtriert werden.

Gegenstand der vorliegenden Erfindung ist auch ein Verfahren zur Herstellung der Folie. Allgemein erfolgt die Herstellung durch ein an sich bekanntes Extrusions- oder Koextrusionsverfahren. Als besonders vorteilhaft hat es sich erwiesen, die verwendeten Additive wie Partikel, UV-Stabilisatoren, Flammschutzmittel, Hydrolysestabilisatoren und Antioxidantien in Form von vorgetrockneten oder vorkristallisierten Masterbatchen vor der Extrusion zuzugeben.

Bevorzugt bei der Masterbatchtechnologie ist, dass die Korngröße und das Schüttgewicht der Masterbatche ähnlich der Korngröße und dem Schüttgewicht des verwendeten Polyesterrohstoffs sind, so dass eine homogene Verteilung erreicht wird, aus der homogene Eigenschaften resultieren.

Die Polyesterfolien können nach bekannten Verfahren aus einem Polyesterrohstoff und gegebenenfalls weiteren Rohstoffen sowie gegebenenfalls weiteren Additiven als ein- oder mehrschichtige Folie hergestellt werden

Die Masterbatche sind bevorzugt vorkristallisiert und/oder vorgetrocknet. Das gleiche gilt für Masterbatche, die Partikel, UV-Stabilisator(en), Flammschutzmittel und/oder andere Additive enthalten. Die Vortrocknung beinhaltet ein graduelles Erhitzen der Masterbatche unter reduziertem Druck (20 bis 80 mbar, vorzugsweise 30 bis 60 mbar, besonders bevorzugt 40 bis 50 mbar) sowie Rühren und gegebenenfalls ein Nachtrocknen bei konstanter, erhöhter Temperatur (ebenfalls unter reduziertem Druck). Die Masterbatche werden vorzugsweise bei Raumtemperatur aus einem Dosierbehälter in der gewünschten Abmischung zusammen mit dem Polyesterrohstoff und gegebenenfalls anderen Rohstoffkomponenten chargenweise in einen Vakuumtrockner, der im Laufe der Trocken- bzw. Verweilzeit ein Temperaturspektrum von 10 bis 160 °C, bevorzugt 20 bis 150 °C, besonders bevorzugt 30 bis 130 °C, durchläuft, gefüllt. Während der etwa 6-stündigen, vorzugsweise 5-stündigen, besonders bevorzugten 4-stündigen, Verweilzeit wird die Rohstoffmischung mit 10 bis 70 Upm, bevorzugt 15 bis 65 Upm, besonders bevorzugt 20 bis 60 Upm, gerührt. Das so vorkristallisierte bzw. vorgetrocknete Rohstoffgemisch wird in einem nachgeschalteten, ebenfalls evakuierten Behälter bei 90 bis 180 °C, bevorzugt 100 bis 170 °C, besonders bevorzugt 110 bis 160 °C, für 2 bis 8 Stunden, bevorzugt 3 bis 7 Stunden, besonders bevorzugt 4 bis 6 Stunden, nachgetrocknet.

Bei dem bevorzugten Extrusions- bzw. Koextrusionsverfahren zur Herstellung der Folie wird so vorgegangen, dass die den einzelnen Schichten der Folie entsprechenden Schmelzen durch eine Flachdüse extrudiert/koextrudiert werden und als weitgehend amorphe Vorfolie auf einer Kühlwalze abgeschreckt werden. Diese Folie wird anschließend erneut erhitzt und in Längs- und Querrichtung bzw. in Quer- und Längsrichtung bzw. in Längs-, in Quer- und nochmals und Längsrichtung und/oder Querrichtung verstreckt (orientiert). Die Folientemperaturen im Streckprozess liegen im allgemeinen 10 bis 60°C über der Glasübergangstemperatur $T_g$ des verwendeten Polyesters; das Streckverhältnis der Längsstreckung liegt üblicherweise bei 2 bis 6, vorzugsweise bei 3 bis 4,5, das der Querstreckung bei 2 bis 5, vorzugsweise bei 3 bis 4,5, und das der gegebenenfalls durchgeführten zweiten Längs- und Querstreckung bei 1,1 bis 5. Die erste Längsstreckung-kann auch-gleichzeitig-mit-der-Querstreckung (Simultanstreckung) durchgeführt werden. Es folgt

die Thermofixierung der Folie bei Ofentemperaturen won 180 bis 260°C, vorzugweise von 220 bis 250°C. Anschließend wird die Folie abgekühlt und gewickelt.

In einer bevorzugten Ausführungsform findet die Thermofixierung zwischen 220 und 250 °C statt, und die Folie wird bei dieser Temperatur um mindestens 1 %, bevorzugt mindestens 2 %, in Querrichtung relaxiert. In einer weiteren bevorzugten Ausführungsform wird anschließend an diese Behandlung nochmals bei Temperaturen zwischen 180 und 150 °C in der Abkühlphase um wiederum mindestens 1 %, bevorzugt mindestens 2 %, in Querrichtung relaxiert.

In einer weiteren bevorzugten Ausführungsform wird die Folie mindestens um den Faktor 3 in MD- und TD-Richtung gestreckt, wobei die Streckung in einem Simultanrahmen stattfindet. Die Thermofixierung findet bei 220 bis 250 °C statt, und die Folie wird bei dieser Temperatur um mindestens 1 %, bevorzugt mindestens 2 %, in Längs- und Querrichtung relaxiert.

Erfindungsgemäß wird auf diese verstreckte und relaxierte Polyesterfolie eine ITO- oder/und ATO-Partikel enthaltende Beschichtung aufgebracht. Weiterhin ist es Gegenstand der Erfindung, dass die Beschichtung mindestens eine weitere leitfähige Komponente enthält oder/und die Folie mit mindestens einer weiteren leitfähigen Schicht ausgerüstet wird.

### 1. Beschreibung der ITO-/ATO-Partikel enthaltenden Beschichtung

Der Gehalt an ITO-/ATO-Nanopartikeln in der Beschichtungsdispersion liegt gewöhnlich bei 1 bis 80 Gew.-%, bevorzugt bei 10 bis 60 Gew.-% und besonders bevorzugt bei 20 bis 40 Gew.-%. Der Anteil an sonstigen Komponenten wie Emulgatoren/Dispergierhilfsmitteln und ähnlichen neben dem/den Lösungsmittel/n liegt im allgemeinen bei ≤ 10 Gew.-%, bevorzugt bei ≤ 4 Gew.-%, besonders bevorzugt bei ≤ 1 Gew.-%.

Erfindungsgemäß wird die Folie mit einer Beschichtungsdispersion beschichtet, die ITO- oder/und ATO-Partikel mit einem $d_{50}$ ≤ 100 nm, bevorzugt ≤ 80 nm und besonders bevorzugt ≤ 60 nm, enthält. Die Herstellung solcher Partikel und die diese Partikel enthaltenden Dispersionen ist u. a. in JP-A-2001-082557 beschrieben. Bevorzugt werden jedoch bereits dispergierte Partikel der Hersteller Nanogate (Saarbrücken, DE) oder Advanced Nano Products Co.,Ltd. (KR) besonders bevorzugt als wässrige Dispersionen eingesetzt. Insbesondere wird die wässrige Dispersion S6N der Fa. Nanogate eingesetzt, die ITO-Partikel enthält.

Gemäß der Erfindung wird mindestens eine Seite der Folie mit einer Dispersion beschichtet, die ITO- und/oder ATO Partikel und gegebenenfalls organisch leitfähige Polymere b) enthält. Die trockene Beschichtung auf der fertigen Folie weist eine Dicke von 5 bis 5000 nm, bevorzugt 100 bis 1500 nm, besonders bevorzugt 20 bis 200 nm, auf. Die Beschichtung wird bevorzugt off-line nach bekannten Verfahren aufgebracht, d. h. nach der Herstellung der verstreckten und relaxierten Folie. Besonders bevorzugt ist die Aufbringung der Beschichtung mittels des "Reverse gravure-roll coating"-Verfahrens, bei dem sich die Beschichtungen äußerst homogen in Schichtdicken bis 200 nm auftragen lassen. Ebenfalls bevorzugt ist die Aufbringung der Beschichtung durch das Meyer-Rod-Verfahren, mit dem sich größere Beschichtungsstärken erzielen lassen. Die Beschichtung wird bevorzugt als Lösung, Suspension oder Dispersion aufgetragen, besonders bevorzugt als wässrige Lösung, Suspension oder Dispersion.

Es ist auch möglich, die ITO-/ATO-Partikel enthaltende Beschichtung auf die Folie nach allen Verstreckungs- und Relaxionsschritten nach der in-line-Methode aufzubringen.

Sofern die erfindungsgemäße Folie keine weitere leitfähige Beschichtung außer der ITO-/ATO-Partikel enthaltenden Schicht aufweist, enthält die ITO-/ATO-Partikel enthaltende Schicht immer eine weitere leitfähige Komponente, bevorzugt eine organisch leitfähige Komponente.

### 2. Beschreibung der möglichen weiteren leitfähigen Schicht

#### 2.1 Metallisierung auf die/unter der ITO-/ATO-Partikel enthaltenden Schicht

Die erfindungsgemäße Folie ist in einer bevorzugten Ausführungsform mindestens einseitig metallisiert, wobei bevorzugt eine Aluminium-, Aluminiumzink- und besonders bevorzugt eine Kupfer-, Silber- oder Goldschicht aufgedampft wird. Die Schichtdicke wird so eingestellt, dass die Transparenz der metallisierten Folie im Bereich von 30 bis 80 %, bevorzugt von 40 bis 75 % und besonders bevorzugt von 50 bis 70 %, liegt. Im Fall einer Aluminiumbedampfung beträgt die Schichtdicke dann 100 bis 1000 Å.

Die Metallisierung wird mit handelsüblichen Metallisierungsanlagen, wie sie z. B. die Fa. Applied Films (Hanau, DE) liefert, aufgebracht. Insbesondere bei Transparenzwerten oberhalb von 45 % hat es sich als günstig erwiesen, wenn die extrem dünnen Metallschichten nicht über eine weitere Reduktion der Metallantragsrate, sondern über eine Erhöhung der Foliengeschwindigkeit bei konstanter Antragsrate wie für 45 % Transparenz erreicht werden. Auf die Metallschicht wird dann eine Schicht aufgebracht, die die ITO-/ATO-Partikel a) enthält.

Die Metallisierung kann gegebenenfalls auch auf die ITO-/ATO-Partikel enthaltende Schicht oder auf eine bereits mit organischem Polymer beschichtete Folie erfolgen.

**2.2 Beschichtung mit einer organisch leitfähige Polymere b) enthaltenden Schicht unter der ITO-/ATO-Partikel enthaltenden Schicht**

Die erfindungsgemäße Folie ist in einer bevorzugten Ausführungsform mindestens einseitig mit einer eine organisch leitfähige Komponente b) enthaltenden Beschichtung ausgerüstet, auf die die ITO-/ATO-Partikel a) enthaltende Schicht aufgebracht wird.

Die die Komponente b) enthaltende leitfähige Schicht kann sowohl in-line als auch off-line aufgebracht werden. Sie kann im Gegensatz zu der ITO-/ATO-Partikel a) enthaltenden Schicht auch nach der Aufbringung noch verstreckt werden. Die zusätzlichen organisch leitfähigen Schichten können auch auf die ITO-/ATO-Partikel a) enthaltende Schicht aufgebracht werden, wobei dies weniger bevorzugt ist.

Es hat sich ferner als günstig erwiesen, wenn die leitfähige Polymere enthaltene Beschichtung bereits kleine Mengen der ITO-/ATO-Partikel enthält. Bevorzugt ist dabei ein Anteil von 0,5 bis 5 Gew.-%, besonders bevorzugt 0,5 bis 2 Gew.-%, in der Beschichtungsdispersion. Durch diese Maßnahme wird gleichzeitig eine verbesserte Haftung der betreffenden Schichten untereinander erreicht.

Die organisch leitfähige Komponente b) in den Schichten kann sowohl aus einer Einzelkomponente als auch in Form einer beliebigen Mischung von elektrisch leitfähigen

Polymeren, im Besonderen substituiertes oder unsubstituiertes Pyrrol enthaltenden Polymeren (wie in US-A-5,665,498 und US-A-5,674,654 beschrieben), substituiertes oder unsubstituiertes Thiophen enthaltenden Polymeren (wie in US-A-5,300,575; US-A-5,312,681; US-A-5,354,613; US-A-5,370,981; US-A-5,372,924; US-A-5,391,472; US-A-5,403,467; US-A-5,443,944; US-A-5,575,898; US-A-4,987,042 and US-A-4,731,408 beschrieben), substituiertes oder unsubstituiertes Anilin enthaltenden Polymeren (wie in US-A-5,716,550 und US-A-5,093,439 beschrieben) und Polyisothianaphthene, bestehen. Das elektrisch leitfähige Polymer kann in organischen Lösungsmitteln oder Wasser oder Mischungen beiderlöslich oderdispergierbarsein. Aus umwelttechnischen Gründen sind wässrige Lösungen oder Dispersionen bevorzugt. Bevorzugte Polyanionen der elektrisch leitfähigen Polymere sind Anionen von Polycarbonsäuren wie Polyacrylsäure, Polymethacrylsäure, Polymaleinsäure oder Polysulfonsäuren wie Polystyrolsulfonsäure, Polyvinylsulfonsäure, wobei die Polysulfonsäuren bevorzugt sind. Die Polysulfonsäuren und Polycarbonsäuren können auch als Copolymere oder Mischungen voneinander eingesetzt werden. Das Molekulargewicht der Polysäuren ist bevorzugt 1.000 bis 2.000.000 und besonders bevorzugt 200.000 bis 500.000 g/mol. Die Polysäuren oder deren Alkalisalze sind allgemein erhältlich, z. B. Polystyrolsulfonsäure und Polyacrylsäure, oder können nach allgemein bekannten Methoden hergestellt werden. Bevorzugte elektrisch leitfähige Polymere im Sinne der Erfindung sind Polypyrrolstyrolsulfonat (beschrieben als Polypyrrol/Polystyrolsulfonsäure in US-A-5,674,654), 3,4-dialkoxysubstituierte Polypyrolstyrolsulfonate und 3,4-dialkoxysubstituiertes Polythiophenstyrolsulfonat. Besonders bevorzugt im Sinne der Erfindung ist Poly(3,4-ethylen-dioxypyrolstyrolsulfonat) und Poly(3,4-ethylen-dioxythiophenstyrol-sulfonat).

Besonders bevorzugt im Sinne der Erfindung ist weiterhin die Verwendung von Baytron P (Poly(3,4-ethylenedioxythiophene)/poly(styrenesulfonate)) der Fa. H.C.Starck (DE). Die leitfähigen Polymere können wie oben beschrieben in wässrigen oder organischen Lösungsmitteln gelöst oder dispergiert werden, und diese Dispersion kann mit der ITO-und/oder ATO-Partikel enthaltenden Dispersion gemischt werden. Besonders bevorzugt im Sinn der Erfindung ist jedoch die Zugabe der organisch leitfähigen Polymere und Gegenionen, z. B. von Baytron P, zur ITO-/ATO Dispersion bzw. dass die organisch leitfähigen Polymere zusammen mit den ITO-/ATO-Nanopartikeln dispergiert werden. Letztere Methode ist besonders bevorzugt, da sich dadurch besonders stabile Dispersionen erzeugen lassen und keine Agglomeration der Nanopartikel bei der Zugabe der organisch leitfähigen Polymere zur Dispersion bzw. der organisch leitfähigen Dispersion zur Dispersion auftritt.

Die die organisch leitfähigen Verbindungen enthaltenden Beschichtungslösungen/Dispersionen sind bevorzugt wasserbasiert und enthalten wasserlösliche Polymere als Binder. Geeignete Polymere sind u. a. Polyvinylalkohol, Polyethylenoxid, Polystyrolsulfonat, Polyacrylamid, hydrophile Kolloide (wie Gelatine) oder wasserunlösliche Latices (besonders bevorzugt sind Latices, die vinylidenchlorid-, polyester- oder polyurethanbasierte Polymere enthalten) oder wasserdispergierbare Polymere wie Polyurethane, Polyester, Polyesterionomere, Polyamide und Polyepoxide. Der Anteil der organisch leitfähigen Komponente b) am getrockneten Rückstand beträgt 0,5 bis 60 Gew.-%, bevorzugt 10 bis 40 Gew.-% und besonders bevorzugt 20 bis 35 Gew.-%.

Wenn die Folie bereits eine leitfähige Schicht aufweist, kann die ITO-/ATO-Partikel a) enthaltende Schicht eine weitere leitfähige Komponente b) enthalten, sie kann aber auch ohne diese weitere leitfähige Komponente verwendet werden. Die Verwendung von organisch leitfähigen Komponenten ist jedoch bevorzugt, da dadurch überraschend der Leitfähigkeitsverlust der Folie nach Biegebeanspruchungen im Verarbeitungsprozess und in der Anwendung deutlich verringert werden kann.

Der Anteil an ITO-/ATO-Partikeln am getrockneten Rückstang schwankt in den Grenzen von 30 bis 99,8 Gew.-%. Bei Beschichtungen ohne einen Anteil der organisch leitfähigen Komponenten b) liegt er bei 90 bis 99,8 Gew.-%, bei Beschichtungen mit organisch leitfähigen Komponenten b) liegt er bei 30 bis 90 Gew.-%, bevorzugt bei 60 bis 85 Gew.-% und besonders bevorzugt bei 70 bis 80 Gew.-%.

Die erfindungsgemäßen ein- oder mehrschichtigen Folien weisen die geforderten guten mechanischen Eigenschaften auf. So beträgt der E-Modul in mindestens einer Folienrichtung (Längsrichtung (MD) und/oder Querrichtung (TD)) mindestens 500 $N/mm^2$, bevorzugt mindestens 2000 $N/mm^2$ und besonders bevorzugt mindestens 4000 $N/mm^2$. Die Reißfestigkeitswerte in mindestens einer Folienrichtung (Längsrichtung (MD) und/oder Querrichtung (TD)) sind ≥ 50 $N/mm^2$, bevorzugt ≥ 100 $N/mm^2$ und besonders bevorzugt ≥ 150 $N/mm^2$. Die Reißdehnungswerte in mindestens einer Folienrichtung (Längsrichtung (MD) und/oder Querrichtung (TD)) sind ≥ 10 %, bevorzugt ≥ 40 % und besonders bevorzugt ≥ 80 %.

Es war mehr als überraschend, dass durch die Kombination von ITO-/ATO-Partikel enthaltender Beschichtung und weiterer leitfähiger Beschichtung sich deutlich höhere Leitfähigkeiten erreichen lassen als dies mit einer reinen Schichtdickenerhöhung der ITO-/ATO-Schicht möglich ist.

Weiterhin war es mehr als überraschend, dass auch die Zugabe von organisch leitfähigem Material zu der ITO-/ATO-Partikel enthaltenden Beschichtung zu einer deutlichen Leitfähigkeitssteigerung führte, die erheblich über der lag, die mit einer alleinigen Erhöhung der ITO-/ATO-Menge zu erreichen war.

Durch die Kombination ihrer Eigenschaften eignen sich die erfindungsgemäßen Folien für eine Vielzahl verschiedener Anwendungen, beispielsweise für Leiterplatten, Flachbandkabel, Smartcards, RFID-Labels, LCD-Displays, Folientastaturen und folienbasierten Schaltungen aller Art.

Die Messung der einzelnen Eigenschaften in den Beispielen erfolgte gemäß den nachstehend angeführten Normen bzw. Verfahren.

## Messmethoden

### Mechanische Eigenschaften

Der E-Modul, die Reißfestigkeit, Reißdehnung und der $F_5$-Wert werden in Längs- und Querrichtung nach ISO 527-1-2 mit Hilfe eines Zug-Dehnungsmessgerätes (Fa. Zwick, Typ 010, Ulm, DE) gemessen.

### Schrumpf

Der thermische Schrumpf wird an quadratischen Folienmustern mit einer Kantenlänge von 10 cm bestimmt. Die Proben werden genau ausgemessen (Kantenlänge $L_0$), 15 Minuten bei 200°C in einem Umlufttrockenschrank getempert und anschließend bei Raumtemperatur genau ausgemessen (Kantenlänge L). Der Schrumpf ergibt sich aus der Gleichung

$$\text{Schrumpf [\%]} = 100 * (L_0 - L) / L$$

### Messung des mittleren Durchmessers $d_{50}$

Die Bestimmung des mittleren Durchmessers $d_{50}$ wird mittels Laser auf einem Malvern Master Sizer nach der Standardmethode durchgeführt; andere Messgeräte sind z. B. Horiba LA 500 oder Sympathec Helos, welche das gleiche Messprinzip verwenden. Die Proben werden dazu in eine Küvette mit Wasser gegeben und diese dann in das Messgerät gestellt. Der Messvorgang ist automatisch und beinhaltet auch die mathematische Bestimmung des $d_{50}$-Wertes.

Der $d_{50}$ Wert- wird dabei definitionsgemäß aus der (relativen) Summenkurve der Partikelgrößenverteilung bestimmt: der Schnittpunkt des 50 %-Ordinatenwertes mit der Summenkurve liefert auf der Abszissenachse sofort den gewünschten $d_{50}$-Wert. Wie dies zu verstehen ist, wird in Figur 1 näher verdeutlicht.

Partikel mit $d_{50}$-Werten unterhalb von 100 nm werden mittels eines Elektronemikroskops qualitativ analysiert, d. h.10 Folienproben werden im Elektronemikroskop analysiert. Die Größe von je 100 zufällig ausgewählten Pigmentteilchen der nanopartikulären Spezies wird vermessen und der Mittelwert bestimmt.

### Siegelnahtfestigkeit

Zur Bestimmung der Siegelnahtfestigkeit werden zwei 15 mm breite Folienstreifen übereinander gelegt und bei 130 °C, einer Siegelzeit von 0,5 s und einem Siegeldruck von 2 bar mit einem Gerät Typ NDS der Fa. Brugger Feinmechanik (München, DE) mit einseitig beheizter Siegelbacke gesiegelt. Die gesiegelte Fläche beträgt etwa 15 x 9 mm. Die Siegelnahtfestigkeit wird nach der T-Peel-Methode mit Hilfe eines Zug-Dehnungsmessgerätes (Fa. Zwick, Typ 010, Ulm, DE) bestimmt. Dabei werden die beiden Streifenenden in die gegenüberliegenden Kluppen eingespannt und mit einer Geschwindigkeit von 200 mm/min auseinander gezogen. Die maximale dabei gemessene Kraft ist die Siegelnahtfestigkeit und wird in N/15mm angegeben.

**Messung des Oberflächenwiderstands**

Gemessen wird in Anlehnung an die AIMCAL-Methode TP-102-78. Es werden ein Ohmmeter und zwei Elektroden mit einer Breite von 2 cm in einem Abstand von 10 cm auf einer festen, nicht leitfähigen, ebenen Unterlage verwendet. Die mindestens 12 x 4 cm messende Probe wird auf die Gummiplatte aufgebracht und die Elektroden mit dem genannten Abstand auf die leitfähige Seite der Probe gelegt und am kalibrierten Ohmmeter der Widerstand in Ohm/$cm^2$ abgelesen.

**Leitfähigkeit nach Biegebelastung**

Zu Beginn der Messung wird der Widerstand der Probe nach oben beschriebener Methode bestimmt. Daraufhin wird eine 18 x 4 cm lange, leitfähig beschichtete Probe der Länge nach in ein Zug-Dehnungsmessgerät (Fa.Zwick,Typ 010, Ulm, DE) eingespannt, wobei der Abstand zwischen den Kluppen 14 cm beträgt und die eingespannte Länge 15 cm beträgt. Der Kluppenabstand wird anschließend 50 mal auf 7 cm verringert und jeweils wieder in die Ausgangsposition zurückgeführt. Die Kluppenvorschubgeschwindigkeit beträgt dabei 7 cm/min. Anschließend wird der Widerstand nach der oben beschriebenen Methode erneut gemessen. Der Test gilt als bestanden, wenn der nach der Biegungsbeanspruchung gemessene Widerstand gegenüber der Ausgangsmessung nicht um mehr als 5 % erhöht ist. Es werden jeweils drei Proben gemessen.

**Messung der Transparenz und Trübung**

Die Messung erfolgt an dem Hazegard Hazemeter XL-211 der Fa. BYK Gardner (s. Figur 2). Das Messgerät ist 30 Minuten vor der Messung einzuschalten. Es ist darauf zu achten, dass der Lichtstrahl durch die Kugel zentrisch an die Austrittsöffnung geht.

**Herstellung, Form und Anzahl der Proben**

Aus der zu untersuchenden Folie werden je 5 Proben mit einer Größe von 100 x 100 mm ausgeschnitten. Die Längs- und Querrichtung werden am Rand gekennzeichnet, da die Messungen in beiden Maschinenrichtungen erfolgen.

**Messung der Transparenz und Trübung**

Schalter 1 "OPEN" drücken
Schalter 2 auf "X10" einstellen und mit dem "Zero"-Knopf Digitalanzeige auf 0.00 kalibrieren
Umschalten des Schalters 1 auf "Referenz" und des Schalters 2 auf "X1"
Mit dem "Calibrate"-Knopf Digitalanzeige auf 100 bringen
Probe in Längsrichtung einlegen
Anzeigewert für die Transparenz ablesen
Die Digitalanzeige mit dem "Calibrate"-Knopf auf 100 kalibrieren
Schalter 1 auf "OPEN" stellen
Anzeigewert für die Trübung in Längsrichtung ablesen
Probe in Querrichtung drehen
Anzeigewert für die Trübung in Querrichtung ablesen

**Auswertung**

Die Transparenz und Trübung erhält man durch die Mittelung der jeweiligen 5 Einzelwerte.

**Folienherstellung**

Polyesterchips wurden gemäß den in den Beispielen angegebenen Verhältnissen gemischt und in einem Wirbelschichttrockner bei 155 °C für 1 Minute vorkristallisiert, anschließend für 3 Stunden in einem Schachttrockner bei 150 °C getrocknet und bei 290 °C in einem Einschneckenextruder aufgeschmolzen. Die geschmolzenen Polymerstränge wurden in einer Koextrusionsdüse zusammengeführt und über eine Abzugswalze (Temperatur der Walze 20 °C) abgezogen. Der Film wurde um den Faktor 3,5 in Maschinenrichtung bei 116 °C (Folientemperatur im Streckspalt) gestreckt und in einem Rahmen bei 110 °C eine Querstreckung um den Faktor 3,2 durchgeführt. Anschließend wurde die Folie bei 229 °C thermofixiert und in Querrichtung um 1 % bei Temperaturen von 229 bis 200 °C und ein weiteres mal um 1,5 % bei Temperaturen zwischen 180 und 150 °C relaxiert. Die Produktionsgeschwindigkeit (Endfoliengeschwindigkeit) betrug 300 m/min.
Endfoliendicke : 50 µm

**Metallisierung**

Die Folien wurden mit einer Metallisierungsanlage Typ TOPBEAM1100 der Fa. Applied Films (Hanau, DE) mit Gold metallisiert. Die Transparenz der Folie nach der Metallisierung betrug 65 %.

**Beschichtung In-Line**

a) Aminosilanbeschichtung
Die Folie wurde nach einer Coronabehandlung nach der Längsreckung einseitig mit wässriger Aminosilandispersion mittels Reverse-Gravure-Coating beschichtet (Bedingungen: 2 Gew.-% Z-6020 der Fa. Dow Corning (DE) in entionisiertem Wasser, Nassantragsgewicht 2,5 g/m$^2$, entspricht einem Trockenantragsgewicht von 16 mg/m$^2$).
b) Leitfähige Beschichtung (nicht die ITO-/ATO-Partikel enthaltende Beschichtung) Die Folie wurde nach einer Coronabehandlmung nach der Längsreckung mit einer Dispersion gemäß den Angaben in EP-A-1 253 166, Beispiel E5, mittels Reverse-Gravure-Coating beschichtet.

**Beschichtung Off-Line**

a) ITO-Beschichtung ohne leitfähiges Polymer
40 Vol.-% einer wässrigen Mischung aus 4,5 Gew.-% eines Copolymers aus 60 Gew.-% Methylmethacrylat und 35 Gew.-% Ethylacrylat und 5 Gew.-% N-Methylacrylamid sowie 0,4 % Triton X 100 wurden mit 60 Vol.-% der ITO-Partikel enthaltenden Dispersion S6N (25 Gew.-% ITO-Nanopartikel) der Fa. Nanogate unter starkem Rühren gemischt und weiter gerührt.
b) ITO-Beschichtung mit leitfähigem Polymer
38 Vol.-% einer wässrigen Mischung aus 4,5 Gew.-% eines Copolymers aus 60
Gew.-% Methylmethacrylat und 35 Gew.-% Ethylacrylat und 5 Gew.-% N-Methylacrylamid sowie 0,4 % Triton X 100 wurden mit 60 Vol.-% der ITO-Partikel enthaltenden Dispersion S6N und 2 Vol.-% Baytron P unter starkem Rühren gemischt und weiter gerührt.

Die nach a) und b) erhaltenen Dispersionen wurden jeweils mittels des Meyer-Rod-Verfahrens auf die Polyesterfolie aufgetragen, so dass die Dicke der getrockneten Schicht 1 µm betrug. Die beschichtete Folie wurde durch einen Ofen bei 110 °C geführt, abschließend mit 170 °C warmer Luft angeblasen und so endgetrocknet.

**Beispiele**

In den Beispielen kommen die folgenden Rohstoffe zum Einsatz:

**Masterbatch MB1**

MB1 enthält 0,4 Gew.-% Sylysia® 310 (Fuji, JP) und 0,8 Gew.-% Aerosil® OX 50 (Degussa, DE) und 98,8 Gew.-% Polyethylenterephtalat (PET). Die Pigmente wurden während der Polykondensation zugegeben. Das Katalysator-/Stabilisatorsystem besteht aus 20 ppm Ti aus Titankatalysator C94 (Fa. Acordis), 50 ppm Mn aus $Mn(Ac)_2$ und 20 ppm P aus Phosphorsäure.

**Masterbatch MB2**

MB2 enthält 0,6 Gew.-% Sylysia 340 und 0,8 Gew.-% Aerosil OX 50 und 98,6 Gew.-% Polyethylenterephtalat (PET). Die Pigmente wurden während der Polykondensation zugegeben. Das Katalysator-/Stabilisatorsystem besteht

aus 300 ppm Sb aus $Sb_2O_3$, 90 ppm Mn aus $Mn(Ac)_2$ und 50 ppm P aus Phosphorsäure.

**Masterbatch MB3**

MB3 enthält 60 Gew.-% Polyethylenterephtalat (PET) und 40 Gew.-% Isophthalat. Die Pigmente wurden während der Polykondensation zugegeben. Das Katalysator-/Stabilisatorsystem besteht aus 20 ppm Ti aus Titankatalysator C94, 50 ppm Mn aus $Mn(Ac)_2$ und 20 ppm P aus Phosphorsäure.

**Masterbatch MB4**

MB4 enthält neben PET 10 Gew.-% des UV-Stabilisators 2-(4,6-Diphenyl-1 ,3,5-triazin-2-yl)-5-(hexyl)-oxyphenol (Tinuvin® 1577, Ciba-Geigy, CH). Das Katalysator-/Stabilisatorsystem besteht aus 20 ppm Ti aus Titankatalysator C94, 50 ppm Mn aus $Mn(Ac)_2$ und 20 ppm P aus Phosphorsäure.

**Rohstoff R1**

100 Gew.-% Polyethylenterephthalat RT 49 der Fa. Kosa (DE)
Das Katalysator-/Stabilisatorsystem besteht aus 20 ppm Ti aus Titankatalysator C94, 50 ppm Mn aus $Mn(Ac)_2$ und 20 ppm P aus Phosphorsäure.

**Rohstoff R2**

100 Gew.%Polyethylennaphthalat,Rohstoff der Fa.(DE)
Das Katalysator-/Stabilisatorsystem besteht aus 20 ppm Ti aus Titankatalysator C94, 50 ppm Mn aus $Mn(Ac)_2$ und 20 ppm P aus Phosphorsäure.

**Rohstoff R3**

100 Gew.-% Polyethylenterephthalat RT 49
Das Katalysator-/Stabilisatorsystem besteht aus 300 ppm Sb aus $Sb_2O_3$, 90 ppm Mn aus $Mn(Ac)_2$ und 50 ppm P aus Phosphorsäure.

**Beispiel 1**

Es wurde eine ABC-Folie gemäß der obigen Beschreibung mit der Dicke 50 µm hergestellt, wobei die Deckschichten A und C jeweils 2 µm dick sind. Die Deckschicht C enthielt 10 Gew-% MB1 und 90 Gew.-% R1, die Basisschicht 70 Gew.-% R1 und 30 Gew.-% eigenes Regenerat, erhalten aus der vorliegenden ABC-Folie, und die Deckschicht A 2,5 Gew.-% MB1 und 97,5 Gew.-% R1. Die Folie wurde, wie oben beschrieben, off-line mit einer ITO-Partikel a) und organische Polymere b) enthaltenden Beschichtung versehen.

**Beispiel 2**

Wie Beispiel 1; die Folie wurde jedoch, wie oben beschrieben, zuerst metallisiert und anschließend off-line mit einer ITO-Partikel enthaltenden Beschichtung versehen.

**Beispiel 3**

Wie Beispiel 2; anstelle der reinen ITO-Partikelbeschichtung wurde jedoch die oben beschriebene Beschichtung mit einer Mischung aus ITO-Partikeln und organisch leitfähigem Polymer durchgeführt.

**Beispiel 4**

wie Bespiel 2; anstelle der Metabollisierung wurde jedoch eine in-line-Beschichtung mit organisch leitfähigem Polymer aufgebracht.

**Beispiel 5**

Wie Beispiel 4; anstelle der reinen ITO-Partikelbeschichtung trat jedoch die oben beschriebene Beschichtung

mit einer Mischung aus ITO-Partikeln und organisch leitfähigem Polymer. Außerdem bestand die Basisschicht der Folie aus 30 Gew.-% Eigenregenerat, 60 Gew.-% R1 und 10 Gew.-% MB4.

**Beispiel 6**

Wie Beispiel 1; die Folie wurde jedoch zuerst in-line mit organisch leitfähigem Polymer, wie oben beschrieben, beschichtet, anschließend metallisiert und abschließend mit einer Beschichtung mit einer Mischung aus ITO-Partikeln und organisch leitfähigem Polymer versehen.

**Beispiel 7**

Wie Beispiel 2; jedoch wurde die Folie vor der Metallisierung, wie oben beschrieben, in-line mit Aminosilan beschichtet.

**Beispiel 8**

Wie Beispiel 1; jedoch wurde die Folie vor der off-line Beschichtung mit einer Mischung aus ITO-Partikeln und organisch leitfähigem Polymer, wie oben beschrieben, in-line mit Aminosilan beschichtet.

**Beispiel 9**

Wie Beispiel 3; jedoch bestand die Deckschicht A, auf die beschichtet wird, zu 95 Gew.-% aus Rohstoff R2 und 5 Gew.-% aus MB1.

**Beispiel 10**

Wie Beispiel 1; jedoch bestand die Deckschicht C aus 95 Gew.-% MB3 und 5 Gew.-% MB1. Die Folie ist durch die Deckschicht C siegelfähig.

**Vergleichsbeispiel 1**

Folie wie in Beispiel 1; jedoch wurde eine Beschichtung off-line aufgebracht, die nur die ITO-Partikel und keine Komponente b) enthielt. Der oben beschriebene Biegetest wurde dabei in zwei von drei Fällen nicht bestanden.

**Vergleichsbeispiel 2**

Die Folie wurde, wie oben beschrieben, hergestellt. Die Folie wurde jedoch nach der Querstreckung nicht thermofixiert und nicht relaxiert. Es handelt sich um eine ABA-Folie. Die Deckschichten enthielten jeweils 40 Gew.-% MB 2 und 60 Gew.-% R3 und die Basisschicht 70 Gew.-% R3 und 30 Gew.-% Eigenregenerat. Die Folie wurde, wie oben beschrieben, zuerst in-line mit organisch leitfähigem Polymer und anschließend off-line mit ITO-Partikeln enthaltenden Beschichtungen versehen.

**Vergleichsbeispiel 3**

Wie Beispiel 1, jedoch wurde die ITO-Partikel und organisch leitfähige Polymere enthaltende Beschichtung analog der Aminosilanbeschichtung in-line aufgebracht.

**Vergleichsbeispiel 4**

Folienherstellung und Beschichtung wurden wie in Beispiel 6 aus EP-A-0 962 486 durchgeführt.
Die Beschichtung erfolgte in allen Beispielen und Vergleichsbeispielen auf die Seite A. Die Eigenschaften der entsprechenden Folien können der Tabelle entnommen werden. Unter Eigenregenerat ist jeweils das Regenerat aus der Folie des betreffenden Beispiels zu verstehen.

Tabelle

| Beispiel | off-line ITO-Beschichtung | off-line ITO+org. leitf.Beschichtung | Metallisierung | in-line org.leitf.Polymer | in-line Aminosilan | Trübung vor off-line Beschichtung [%] | Schrumpf TD 200 °C [%] | Transparenz beschichtete Folie [%] | Leitfähigkeit [Ohm/cm$^2$] | Biegetest bestanden* |
|---|---|---|---|---|---|---|---|---|---|---|
| 1 | | + | | | | 1,8 | 1,5 | 83 | $7*10^5$ | ja |
| 2 | + | | + | | | 2 | 1,2 | 60 | $3*10^4$ | (ja) |
| 3 | | + | + | | | 1,9 | 1,3 | 58 | $4*10^2$ | ja |
| 4 | + | | | + | | 2,1 | 1,4 | 84 | $5*10^4$ | (ja) |
| 5 | | + | | + | | 2,2 | 0,9 | 80 | $6*10^2$ | ja |
| 6 | | + | + | + | + | 2,2 | 1,1 | 51 | $1*10^2$ | ja |
| 7 | + | | + | | + | 2,1 | 1,0 | 59 | $1*10^4$ | (ja) |
| 8 | | + | | | + | 2,0 | 1,1 | 82 | $2*10^5$ | ja |
| 9 | | + | + | | | 1,7 | 0,8 | 59 | $2*10^2$ | ja |
| 10 | | + | | | | 1,7 | 1,5 | 83 | $6*10^5$ | ja |
| VB** | | | | | | | | | | |
| 1 | + | | | | | 1,7 | 1,5 | 85 | $5*10^7$ | nein |
| 2 | | + | | | | 6 | 45 | 75 | $3*10^8$ | (ja) |
| 3<br>4 | | | | + inkl. ITO<br>in-line | | 4 | 1,6<br>5,2 | 65<br>77 | $2*10^9$<br>$3*10^8$ | (nein) |

* Biegetest: Leitfähigkeit nach Biegebeanspruchung: ja = alle drei Proben haben den Test bestanden, (ja) = nur zwei Proben haben bestanden, (nein) = zwei von drei Proben haben den Test nicht bestanden, nein = alle drei Proben haben den Test nicht bestanden

** VB = Vergleichsbeispiel

**Patentansprüche**

1. Transparente, elektrisch leitfähige, biaxial verstreckte, ein- oder mehrschichtige Polyesterfolie, **dadurch gekennzeichnet, dass** sie eine Beschichtung aufweist, die a) leitfähige ITO (Indiumzinnoxyd)- oder ATO (Antimonzinnoxyd)-Partikel, die einen $d_{50} \leq 100$ nm aufweisen, oder eine Mischung davon und zusätzlich weitere leitfähige Komponenten b) enthält, wobei sich diese leitfähigen Komponenten b) entweder in der ITO- oder ATO-Partikel oder eine Mischung davon enthaltenden Schicht oder in einer damit in Kontakt stehenden Schicht befinden und wobei die ITO- oder ATO-Partikel oder eine Mischung davon enthaltende Schicht eine Dicke von 0,05 bis 5 $\mu$m aufweist.

2. Folie nach Anspruch 1, **dadurch gekennzeichnet, dass** der Polyester Polyethylenterephthalat, Polybutylenterephthalat, Polyethylennaphthalat oder eine Mischung daraus enthält.

3. Folie nach Anspruch 1 oder 2, **dadurch gekennzeichnet, dass** der Anteil an ITO-/ATO-Partikeln am getrockneten Rückstand der Beschichtung in den Grenzen von 30 bis 99,8 Gew.% liegt.

4. Folie nach Anspruch 3, **dadurch gekennzeichnet, dass** der Anteil an ITO-/ATO-Partikein bei Beschichtungen ohne einen Anteil der organisch leitfähigen Komponenten b) bei 90 bis 99,8 Gew.-% und bei Beschichtungen mit organisch leitfähigen Komponenten b) bei 30 bis 90 Gew.-% liegt.

5. Folie nach einem oder mehreren der Ansprüche 1 bis 4, **dadurch gekennzeichnet, dass** die leitfähige Komponente b) ein organisch leitfähiges Polymer ist.

6. Folie nach einem oder mehreren der Ansprüche 1 bis 4, **dadurch gekennzeichnet, dass** die leitfähige Komponente b) eine Metallschicht ist.

7. Folie nach einem oder mehreren der Ansprüche 1 bis 5, **dadurch gekennzeichnet, dass** das organisch leitfähige Polymer b) ein substituiertes oder unsubstituiertes Pyrrol enthaltendes Polymer, ein substituiertes oder unsubstituiertes Thiophen enthaltendes Polymer, ein substituiertes oder unsubstituiertes Anilin enthaltendes Polymer oder ein Polyisothianaphthen ist.

8. Folie nach einem oder mehreren der Ansprüche 1 bis 7, **dadurch gekennzeichnet, dass** der Anteil der organisch leitfähigen Komponente b) am getrockneten Rückstand 0 bis 60 Gew.-% beträgt.

9. Folie nach einem oder mehreren der Ansprüche 1 bis 8, **dadurch gekennzeichnet, dass** die Folie partikuläre Additive wie Füllstoffe, Antiblockmittel und weitere Additive wie UV-Stabilisatoren, Flammschutzmittel, Hydrolysestabilisatoren und Antioxidantien enthält.

10. Folie nach einem oder mehreren der Ansprüche 1 bis 9, **dadurch gekennzeichnet, dass** die Folie eine Silikonbeschichtung aufweist.

11. Folie nach einem oder mehreren der Ansprüche 1 bis 10, **dadurch gekennzeichnet, dass** die eingesetzte Polyesterfolie eine dreischichtige A-B-C- oder A-B-A-Folie ist.

12. Verfahren zur Herstellung einer transparenten, elektrisch leitfähigen, biaxial verstreckten, ein- oder mehrschichtigen Polyesterfolie nach Anspruch 1, **dadurch gekennzeichnet, dass** man die den einzelnen Schichten der Folie entsprechenden Schmelzen zusammen durch eine Schlitzdüse extrudiert, die erhaltene Folie abkühlt, anschließend erneut erhitzt, biaxial orientiert, dann thermofixiert und abkühlt, auf die abgekühlte Folie eine Beschichtung aus a) leitfähigen ITO (Indiumzinnoxyd)- oder ATO (Antimonzinnoxyd)-Partikeln oder einer Mischung davon mit einem $d_{50}$ von kleiner/gleich 100 nm und zusätzlich weiteren leitfähigen Komponenten b) aufbringt, wobei sich diese leitfähigen Komponenten b) entweder in der ITO- oder ATO-Partikel oder eine Mischung davon enthaltenden Schicht oder in einer damit in Kontakt stehenden Schicht befinden.

13. Verwendung der Folie nach einem oder mehreren der Ansprüche 1 bis 11 in Leiterplatten, Flachbandkabeln, Smartcards, RFID-Labels, LCD-Displays, Folientastaturen und folienbasierten Schaltungen aller Art.

## Claims

1. A transparent, electrically conductive biaxially oriented, single- or multilayer polyester film, which has a coating which comprises a) conductive particles of ITO (indium tin oxide) or of ATO (antimony tin oxide) which have a $d_{50}$ of ≤ 100 nm, or a mixture of these particles and also comprises other conductive components b), these conductive components b) being found either in the layer comprising particles of ITO or of ATO or a mixture of these particles or in a layer in contact therewith and where the thickness of the layer comprising particles of ITO or of ATO or a mixture of these particles is from 0.05 to 5 μm.

2. The film as claimed in claim 1, wherein the polyester is polyethylene terephthalate, polybutylene terephthalate, polyethylene naphthalate, or a mixture thereof.

3. The film as claimed in claim 1 or 2, wherein the proportion of ITO/ATO particles, based on the dry residue of the coating, is within the range from 30 to 99.8 % by weight.

4. The film as claimed in claim 3, wherein the proportion of ITO/ATO particles is from 90 to 99.8 % by weight in the case of coatings without any content of the organic conductive components b) and is from 30 to 90 % by weight in the case of coatings with organic conductive components b).

5. The film as claimed in one or more of claims 1 to 4, wherein the conductive component b) is an organic conductive polymer.

6. The film as claimed in one or more of claims 1 to 4, wherein the conductive component b) is a metal layer.

7. The film as claimed in one or more of claims 1 to 5, wherein the organic conductive polymer b) is a substituted or unsubstituted pyrrole-containing polymer, a substituted or unsubstituted thiophene-containing polymer, a substituted or unsubstituted aniline-containing polymer, or a polyisothianaphthene.

8. The film as claimed in one or more of claims 1 to 7, wherein the content of the organic conductive component b), based on the dry residue, is from 0 to 60 % by weight.

9. The film as claimed in one or more of claims 1 to 8, which comprises particulate additives, such as fillers, antiblocking agents, and other additives, such as UV stabilizers, flame retardants, hydrolysis stabilizers, and antioxidants.

10. The film as claimed in one or more of claims 1 to 9, which has a silicone coating.

11. The film as claimed in one or more of claims 1 to 10, wherein the polyester film used is a three-layer A-B-C or A-B-A film.

12. A process for producing a transparent, electrically conductive, biaxially oriented, single- or multilayer polyester film as claimed in claim 1, which comprises extruding, together through a flat-film die, the melts corresponding to the individual layers of the film, cooling the resultant film, and then reheating it, biaxially orienting it, and then heat-setting it and cooling it, and applying, to the cooled film, a coating composed of a) conductive particles of ITO (indium tin oxide) or of ATO (antimony tin oxide), or of a mixture of these particles with $d_{50}$ less than or equal to 100 nm, and also of other conductive components b), these conductive components b) being found either in the layer comprising particles of ITO or comprising particles of ATO, or comprising a mixture of these, or in a layer in contact therewith.

13. The use of the film as claimed in one or more of claims 1 to 11 in printed circuit boards, ribbon cables, Smartcards, RFID labels, LCD displays, membrane keyboards, or film-based circuits of any type.

## Revendications

1. Feuille de polyester transparente, électroconductrice, étirée biaxialement, à une ou plusieurs couches, **caractérisée en ce qu'**elle présente un revêtement, qui contient a) des particules conductrices de type ITO (oxyde d'indium et d'étain) ou de type ATO (oxyde d'antimoine et d'étain), qui présentent une valeur $d_{50}$ ≤ 100 nm, ou un mélange de celles-ci et, en outre, d'autres composants conducteurs b), dans laquelle ces composants conducteurs b) se trouvent dans la couche contenant les particules d'ITO ou d'ATO ou un mélange de celles-ci ou dans une couche se trouvant

en contact avec celle-ci et dans laquelle la couche contenant des particules d'ITO ou d'ATO ou un mélange de celles-ci présente une épaisseur de 0,05 à 5 μm.

2. Feuille selon la revendication 1, **caractérisée en ce que** le polyester contient du poly(téréphtalate d'éthylène), du poly(téréphtalate de butylène), du poly(naphtalate d'éthylène) ou un mélange de ceux-ci.

3. Feuille selon la revendication 1 ou 2, **caractérisée en ce que** la proportion de particules ITO/ATO sur le résidu séché du revêtement se situe dans les limites de 30 à 99,8 % en poids.

4. Feuille selon la revendication 3, **caractérisée en ce que** la proportion de particules ITO/ATO dans des revêtements exempts d'une fraction des composants organiques conducteurs b) se situe à une valeur de 90 à 99,8 % en poids et, dans des revêtements dotés de composants organiques conducteurs b), à une valeur de 30 à 90 % en poids.

5. Feuille selon l'une quelconque ou plusieurs des revendications 1 à 4, **caractérisée en ce que** le composant conducteur b) est un polymère organique conducteur.

6. Feuille selon l'une quelconque ou plusieurs des revendications 1 à 4, **caractérisée en ce que** le composant conducteur b) est une couche de métal.

7. Feuille selon l'une quelconque ou plusieurs des revendications 1 à 5, **caractérisée en ce que** le polymère organique conducteur b) est un polymère contenant du pyrrole substitué ou non substitué, un polymère contenant du thiophène substitué ou non substitué, un polymère contenant une aniline substitué ou non substitué ou est un polyisothianaphtène.

8. Feuille selon l'une quelconque ou plusieurs des revendications 1 à 7, **caractérisée en ce que** la proportion des composants organiques conducteurs b) sur le résidu séché est de 0 à 60 % en poids.

9. Feuille selon l'une quelconque ou plusieurs des revendications 1 à 8, **caractérisée en ce que** la feuille contient des additifs particulaires, tels que des charges, des agents antibloquants, et d'autres additifs, tels que des stabilisateurs UV, des agents ignifuges, des stabilisants contre l'hydrolyse et des antioxydants.

10. Feuille selon l'une quelconque ou plusieurs des revendications 1 à 9, **caractérisée en ce que** la feuille présente un revêtement de silicone.

11. Feuille selon l'une quelconque ou plusieurs des revendications 1 à 10, **caractérisée en ce que** la feuille de polyester utilisée est une feuille à trois couches du type A-B-C ou A-B-A .

12. Procédé de fabrication d'une feuille transparente, électroconductrice, étirée biaxialement à une ou plusieurs couches selon la revendication 1, **caractérisé en ce que** l'on extrude les masses fondues correspondant aux couches individuelles ensemble à travers une filière à fente, on refroidit la feuille obtenue, puis on la chauffe à nouveau, on l'oriente biaxialement, puis on procède à une thermofixation et on la refroidit, on applique sur la feuille refroidie un revêtement constitué a) de particules conductrices d'ITO (oxyde d'indium et d'étain) ou d'ATO (oxyde d'antimoine et d'étain) ou d'un mélange de celles-ci ayant une valeur $d_{50}$ inférieure ou égale à 100 nm et, en outre, d'autres composants conducteurs b), dans lequel ces composants conducteurs b) se trouvent dans la couche contenant les particules d'ITO ou d'ATO ou un mélange de celles-ci ou dans une couche se trouvant en contact avec celle-ci.

13. Utilisation de la feuille selon l'une quelconque ou plusieurs des revendications 1 à 11 dans des cartes de circuits imprimés, des câbles en nappes, des cartes à puce, des balises RFID, des écrans LCD, des claviers à membrane et des circuits de tout type à base de feuille.

**Figur 1**

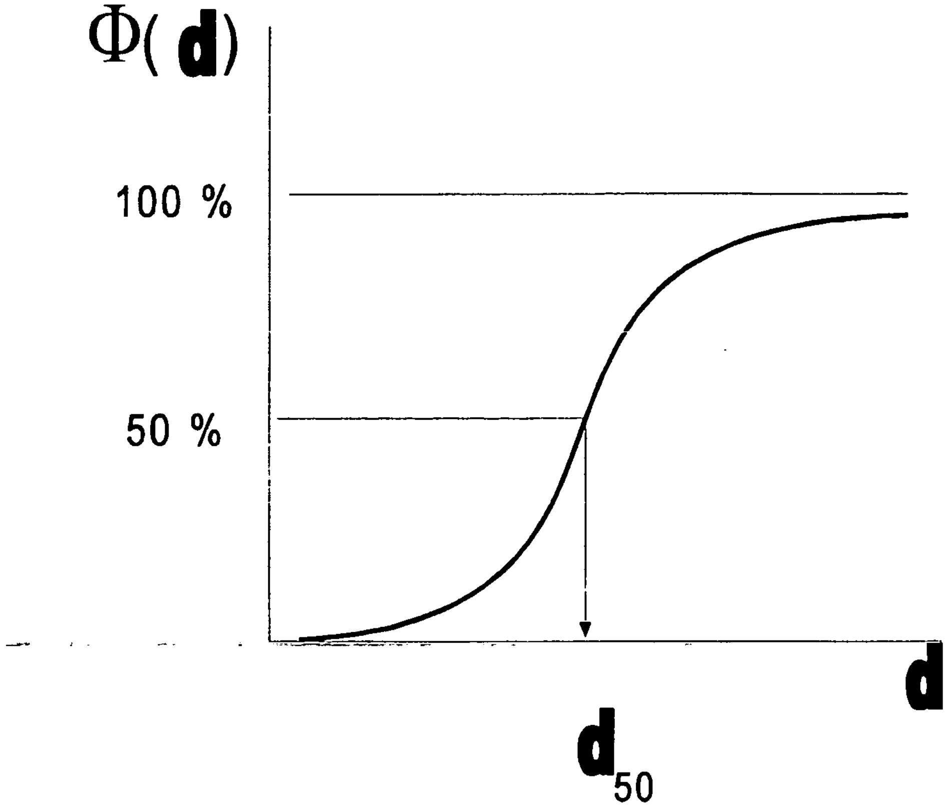

**Figur 2**

Anzeigewert für die Trübung in Querrichtung ablesen

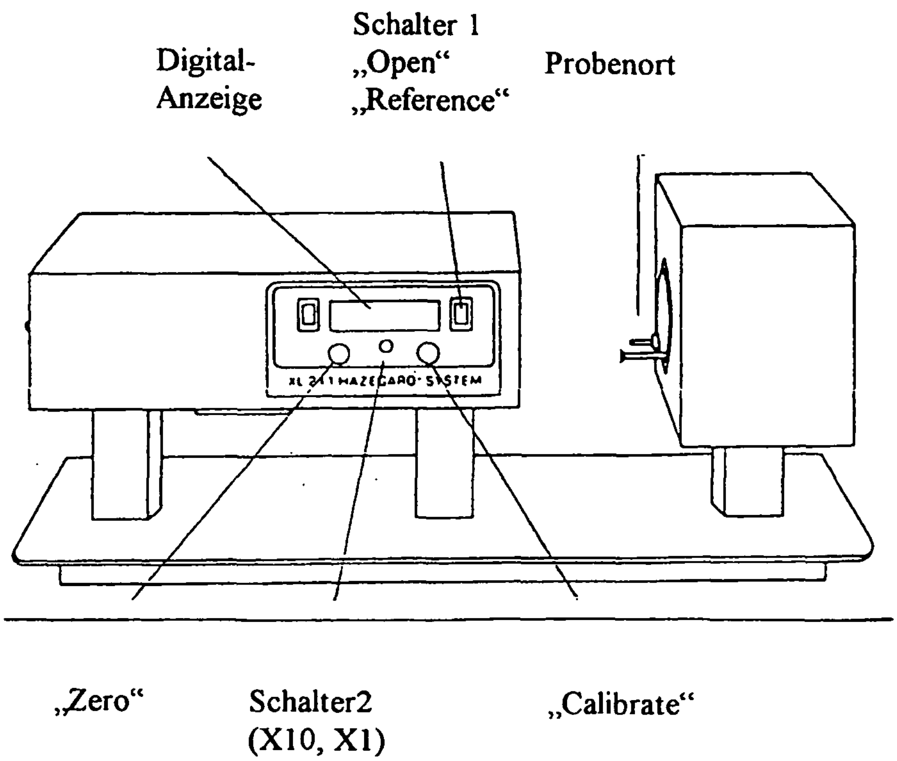

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 200312799 A, von Toyo Boseki
- JP 2000188432 A
- JP 2001099924 A
- JP 2003154594 C
- EP 1020762 B
- EP 0962486 B
- DE 10302035
- DE 10302036
- US 5728339 A
- EP 0359017 B
- EP 0144948 A
- JP 2001082557 A
- US 5665498 A
- US 5674654 A
- US 5300575 A
- US 5312681 A
- US 5354613 A
- US 5370981 A
- US 5372924 A
- US 5391472 A
- US 5403467 A
- US 5443944 A
- US 5575898 A
- US 4987042 A
- US 4731408 A
- US 5716550 A
- US 5093439 A
- EP 1253166 A
- EP 0962486 A